# EUROPEAN PATENT APPLICATION

(11) **EP 4 412 423 A1**
(43) Date of publication of application: **07.08.2024**
(21) Application number: 23159589.3
(22) Date of filing: 02.03.2023
(51) Int. Cl.: H10B 41/27, H10B 41/50, H10B 43/27, H10B 43/50

(54) **SEMICONDUCTOR STRUCTURE FOR 3D MEMORY AND MANUFACTURING METHOD THEREOF**

(30) Priority: 06.02.2023 US 202318164623
(71) Applicant: MACRONIX INTERNATIONAL CO., LTD., Hsinchu (TW)
(72) Inventor: SHEN, Kuan-Yuan, Zhubei City, Hsinchu County (TW); CHIU, Chia-Jung, Zhubei City, Hsinchu County (TW)
(74) Representative: Kurig, Thomas

(57) **Abstract**

Provided are a semiconductor structure for a 3D memory and a manufacturing method thereof. The semiconductor structure may be used in a 3D AND flash memory. The semiconductor structure includes a substrate having a memory array region and a staircase region, an insulating layer, a stacked structure and a vertical channel (VC) structure. The insulating layer is disposed on the substrate. The stacked structure is disposed on the insulating layer. The stacked structure includes first dielectric layer separated from each other, and the stacked structure in the staircase region has a staircase profile. The VC structure is disposed in the stacked structure in the memory array region and penetrates through the stacked structure. There is a vertical hole in the stacked structure and the insulating layer in the staircase region, and a third dielectric layer is filled in the vertical hole.

## Description

### BACKGROUND

### Technical Field

The present invention relates a semiconductor device and a manufacturing method thereof, and particularly to a semiconductor structure for three-dimensional (3D) memory and a manufacturing method thereof.

### Description of Related Art

A non-volatile memory, such as a flash memory, has the advantage that the stored data will not disappear after power off, so it has become a kind of memory widely used in personal computers and other electronic apparatuses.

In the current 3D flash memory, in the memory array region, the vertical channel (VC) hole is formed in a stacked structure composed of dielectric layers and conductive layers as gates, and in the peripheral region, also called the staircase region, the vertical hole (VH) is formed to penetrate through the staircase structure and the insulating layer below the staircase structure.

Generally speaking, the vertical channel hole in the memory array region and the vertical hole in the peripheral region are formed in the same step, and in the subsequent process, the vertical channel hole and the vertical hole are filled with the same material. For example, a channel layer and a dielectric layer are formed in the vertical channel hole to form a vertical channel structure, and the same layers are formed in the vertical hole at the same time.

However, the vertical channel hole in the memory array region and the vertical hole in the peripheral region usually have different depths, and thus it is difficult to form the vertical channel hole and the vertical hole simultaneously in the same etching process. In addition, since the vertical hole in the peripheral region is not used to form the channel structure, additional steps may be performed to remove the channel layer in the vertical hole in the subsequent process, resulting in complicated process steps and increased costs.

### SUMMARY

The present invention provides a semiconductor structure for a 3D memory, in which the material filled in the vertical hole in the staircase region is different from the material of the vertical channel structure in the memory array region.

The present invention provides a manufacturing method of a semiconductor structure for a 3D memory, in which the vertical hole in the staircase region and the vertical channel hole in the memory array region are formed in different steps.

The semiconductor structure for a 3D memory of the present invention includes a substrate, an insulating layer, a stacked structure and a vertical channel structure. The substrate has a memory array region and a staircase region. The insulating layer is disposed on the substrate. The stacked structure is disposed on the insulating layer, wherein the stacked structure comprises a plurality of first dielectric layers separated from each other, and the stacked structure in the staircase region has a staircase profile. The vertical channel structure is disposed in the stacked structure in the memory array region and penetrates through the stacked structure. There is a vertical hole in the stacked structure and the insulating layer in the staircase region, and the third dielectric layer is filled in the vertical hole.

In an embodiment of the semiconductor structure of the present invention, the first dielectric layer includes an oxide layer.

In an embodiment of the semiconductor structure of the present invention, the third dielectric layer includes an oxide layer.

In an embodiment of the semiconductor structure of the present invention, the dielectric stacked structure in the memory array region has a vertical channel hole, and the vertical channel structure is disposed in the vertical channel hole.

In an embodiment of the semiconductor structure of the present invention, the vertical channel structure further includes a channel layer disposed on a sidewall of the vertical channel hole, a dielectric pillar filled in the vertical channel hole, and a source pillar and a drain pillar disposed in the dielectric pillar and separated from each other.

In an embodiment of the semiconductor structure of the present invention, the stacked structure further includes a plurality of gate layers, and the gate layers and the first dielectric layers are stacked alternately.

In an embodiment of the semiconductor structure of the present invention, the semiconductor structure further includes a ground layer disposed between the dielectric stacked structure and the insulating layer, wherein the vertical channel structure penetrates through the ground layer.

In an embodiment of the semiconductor structure of the present invention, the semiconductor structure further includes a device structure layer disposed between the substrate and the insulating layer, wherein the vertical hole exposes the device structure layer.

In an embodiment of the semiconductor structure of the present invention, the semiconductor structure further includes a conductive pillar disposed in the third dielectric layer and electrically connected to the device structure layer.

The manufacturing method of a semiconductor structure for a 3D memory of the present invention includes the following steps. A substrate is provided, wherein the substrate has a memory array region and a staircase region. An insulating layer is formed on the substrate. A stacked structure is formed on the insulating layer, wherein the stacked structure comprises a plurality of first dielectric layers separated from each other, and the stacked structure in the staircase region has a staircase profile. A vertical channel structure is formed to penetrate through the stacked structure in the stacked structure in the memory array region. A vertical hole is formed in the stacked structure in the staircase region and the insulating layer. The vertical hole is filled with a third dielectric layer.

In an embodiment of the manufacturing method of a semiconductor structure, the vertical hole and the third dielectric layer are formed before the vertical channel structure is formed.

In an embodiment of the manufacturing method of a semiconductor structure, a method for forming the vertical channel structure and the vertical hole includes the following steps. A cap layer is formed on the dielectric stacked structure. A part of the cap layer, a part of the dielectric stacked structure and a part of the insulating layer in the staircase region are removed to form the vertical hole. The third dielectric layer is filled in the vertical hole. A part of the cap layer and a part of the stacked structure in the memory array region are removed to form a vertical channel hole. The vertical channel structure is formed in the vertical channel hole.

In an embodiment of the manufacturing method of a semiconductor structure, a method for forming the vertical channel structure includes the following steps. A channel layer is formed on a sidewall of the vertical channel hole. A dielectric pillar is formed to fill the vertical channel hole.

In an embodiment of the manufacturing method of a semiconductor structure, the vertical hole and the third dielectric layer are formed after the vertical channel structure is formed.

In an embodiment of the manufacturing method of a semiconductor structure, a method for forming the vertical channel structure and the vertical hole includes the following steps. A cap layer is formed on the stacked structure. A part of the cap layer and a part of the stacked structure in the memory array region are removed to form a vertical channel hole. The third dielectric layer is filled in the vertical hole. A part of the cap layer and a part of the stacked structure in the staircase region are removed to form a vertical channel hole. The vertical channel structure is filled in the vertical channel hole.

In an embodiment of the manufacturing method of a semiconductor structure, a method for forming the vertical channel structure includes the following steps. A channel layer is formed on a sidewall of the vertical channel hole. A dielectric pillar is formed to fill the vertical channel hole.

In an embodiment of the manufacturing method of a semiconductor structure, the manufacturing method further includes forming a source pillar and a drain pillar in the vertical channel structure after forming the vertical channel structure and before forming the vertical hole and the third dielectric layer.

In an embodiment of the manufacturing method of a semiconductor structure, a method for forming the vertical channel structure, the source pillar, the drain pillar and the vertical hole includes the following steps. A cap layer is formed on the stacked structure. A part of the cap layer and a part of the stacked structure in the memory array region are removed to form a vertical channel hole. The vertical channel structure is formed in the vertical channel hole, wherein the vertical channel structure comprises a channel layer formed on a sidewall of the vertical channel hole, a fourth dielectric layer filled the vertical channel hole and a fifth dielectric layer formed in the fourth dielectric layer. The fourth dielectric layer between the fifth dielectric layer and the channel layer is removed. A conductive layer is filled between the fifth dielectric layer and the channel layer to form the source pillar and the drain pillar. A part of the cap layer, a part of the stacked structure and a part of the insulating layer in the staircase region are removed to form the vertical hole. The third dielectric layer is filled in the vertical hole.

In an embodiment of the manufacturing method of a semiconductor structure, the manufacturing method further includes forming a conductive pillar in the third dielectric layer after forming the third dielectric layer.

embodiment of the manufacturing method of a semiconductor structure, the stacked structure further includes a plurality of gate layers, and the gate layers and the first dielectric layers are stacked alternately.

Based on the above, in the present invention, the vertical channel hole in the memory array region and the vertical hole in the staircase region with different depths are formed in different steps, so the difficulty of the process may be effectively reduced.

In addition, since the vertical channel structure and the dielectric layer in the vertical hole are formed in different steps, it is not necessary to form the same material layer as the vertical channel structure in the vertical hole, that is, the structure in the vertical hole may be different from the vertical channel structure. In this way, additional steps may not be performed in the subsequent process to remove unwanted layers, such as the channel layer, in the vertical hole.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIGs. 1A to 1F are schematic cross-sectional views of the manufacturing process of a semiconductor structure for a 3D memory of the first embodiment of the present invention.
FIGs. 2A to 2C are schematic cross-sectional views of the manufacturing process for a 3D memory of an embodiment of the present invention.
FIGs. 3A to 3C are schematic cross-sectional views of the manufacturing process of a semiconductor structure for a 3D memory of the second embodiment of the present invention.
FIGs. 4A to 4C are schematic cross-sectional views of the manufacturing process of a semiconductor structure for a 3D memory of the third embodiment of the present invention.

### DESCRIPTION OF THE EMBODIMENTS

The embodiments are described in detail below with reference to the accompanying drawings, but the embodiments are not intended to limit the scope of the present invention. In addition, the drawings are for illustrative purposes only and are not drawn to the original dimensions. For the sake of easy understanding, the same elements in the following description will be denoted by the same reference numerals.

In the text, the terms mentioned in the text, such as "comprising", "including", "containing" and "having" are all open-ended terms, i.e., meaning "including but not limited to".

In addition, directional terms such as "on" and "under" mentioned herein are only used to refer to the directions of the drawings and are not used to limit the disclosure. Therefore, it should be understood that "on" may be used interchangeably with "under", and when an element such as a layer or a film is placed "on" another element, the element may be directly placed on the other element or there may be an intermediate element. On the other hand, when an element is described to be placed "directly" on another element, there is no intermediate element between the two.

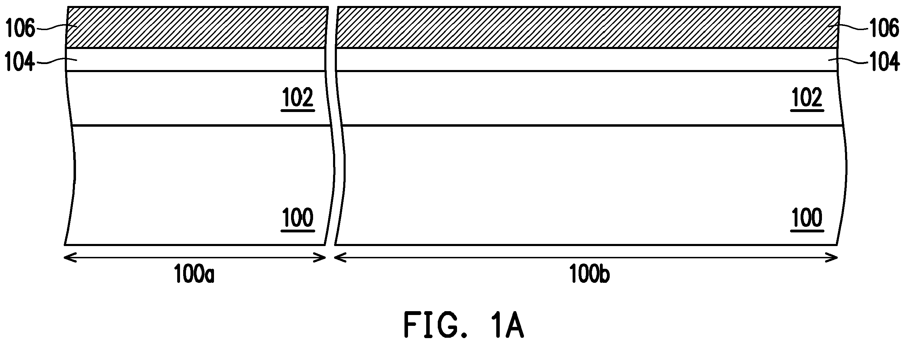

FIGs. 1A to 1F are schematic cross-sectional views of the manufacturing process of a semiconductor structure for a 3D memory of the first embodiment of the present invention.

Referring to FIG. 1A, a substrate 100 is provided. In the present embodiment, the substrate 100 is, for example, a silicon substrate or a silicon-on-insulator (SOI) substrate. The substrate 100 has a memory array region 100a and a staircase region 100b. Then, a device structure layer 102 is formed on the substrate 100. The device structure layer 102 is electrically connected to the substrate 100. To make the drawing clear and easy to describe, the detailed structure of the device structure layer 102 is not shown in FIG. 1A.

The device structure layer 102 may include various commonly known semiconductor devices. For example, in the present embodiment, the device structure layer 102 may include the metal oxide semiconductor (MOS) transistor formed at the surface of the substrate 100, the interconnect structure electrically connected to the MOS transistor and the dielectric layer covering the MOS transistor and the interconnect structure, but the present invention is not limited thereto. In other embodiments, the device structure layer 102 may further include other semiconductor devices well known to those skilled in the art. In addition, the method for forming the device structure layer 102 is well known to those skilled in the art, and will not be further described here.

Then, an insulating layer 104 is formed on the device structure layer 102. The insulating layer 104 may be used to electrically separated the subsequently formed conductive layer from the device structure layer 102. In the present embodiment, the insulating layer 104 is a silicon oxide layer, but the present invention is not limited thereto. The method for forming the insulating layer 104 is well known to those skilled in the art, and will not be further described here.

Next, a ground layer 106 is formed on the insulating layer 104. The ground layer 106 may be used to transmit charges generated in subsequent processes to the substrate 100. In the present embodiment, the ground layer 106 is a polysilicon layer, but the present invention is not limited thereto. In other embodiments, the ground layer 106 may be other conductive layer, such as a metal layer. Depending on the actual situation, the ground layer 106 may be omitted in other embodiments.

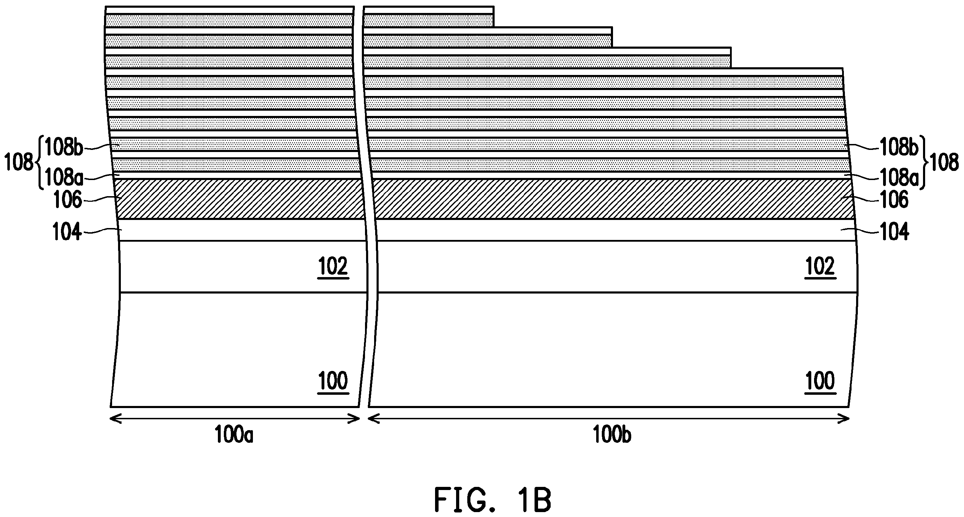

Referring to FIG. 1B, a dielectric stacked structure 108 is formed on the ground layer 106. In the present embodiment, the dielectric stacked structure 108 includes a plurality of first dielectric layers 108a and a plurality of second dielectric layers 108b alternately stacked on the substrate 100, and numbers of the first dielectric layers 108a and the second dielectric layers 108b are not limited in the present invention. In the present embodiment, the first dielectric layer 108a is an oxide layer, and the second dielectric layer 108b is a nitride layer, but the present invention is not limited thereto. In other embodiments, the first dielectric layer 108a and the second dielectric layer 108b may be other dielectric material layers, as long as there is an etching selectivity between the first dielectric layer 108a and the second dielectric layer 108b. Furthermore, in the staircase region 100b, the dielectric stacked structure 108 has a staircase profile. The method for forming the dielectric stacked structure 108 to have a staircase profile is well known to those skilled in the art and will not be further described here.

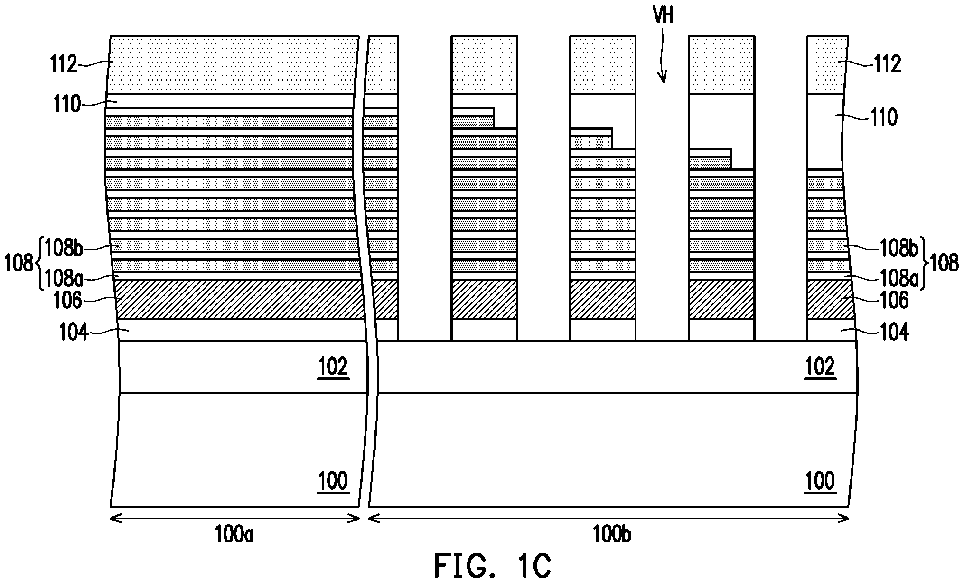

Referring to FIG. 1C, a cap layer 110 is formed on the dielectric stacked structure 108. The cap layer 110 covers the dielectric stacked structure 108 and has a flat top surface. In the present embodiment, the cap layer 110 is an oxide layer, but the present invention is not limited thereto. The method for forming the cap layer 110 may include the following steps. A cap material layer is formed on the dielectric stacked structure 108. Then, a planarization process is performed. The planarization process is, for example, a chemical mechanical polishing (CMP) process. Next, a patterned mask layer 112 is formed on the cap layer 110. In the present embodiment, the patterned mask layer 112 is a photoresist (PR) layer, but the present invention is not limited thereto. The patterned mask layer 112 covers the memory array region 100a, and exposes a part of the cap layer 110 in the staircase region 100b. Afterwards, the patterned mask layer 112 is used as an etching mask, and an etching process is performed to remove the cap layer 110 exposed by the patterned mask layer 112 and the dielectric stacked structure 108, the ground layer 106 and the insulating layer 104 thereunder to form vertical holes VH. The etching process is, for example, an anisotropic etching process. In the present embodiment, the vertical holes VH expose the conductive pads (not shown) in the device structure layer 102, but the present invention is not limited thereto.

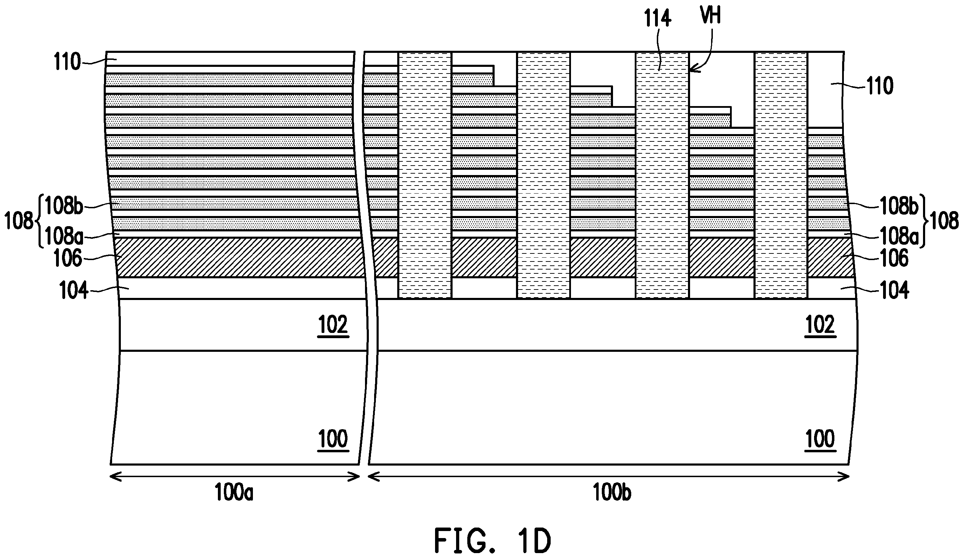

Referring to FIG. 1D, the patterned mask layer 112 is removed. Then, a third dielectric layer 114 is filled in the vertical holes VH. In the present embodiment, the third dielectric layer 114 is an oxide layer, but the present invention is not limited thereto. The method for forming the third dielectric layer 114 may include the following steps. A dielectric material layer is fomed on the cap layer 110. Then, a planarization process is performed to remove the dielectric material layer outside the vertical holes VH. Therefore, the third dielectric layer 114 is completely filled the vertical holes VH.

In the present embodiment, after the planarization process, the cap layer 110 on the top surface of the dielectric stacked structure 108 is remained, but the present invention is not limited thereto. In other embodiments, after the planarization process is performed, the uppermost first dielectric layer 108a in the dielectric stacked structure 108 is exposed, that is, the uppermost first dielectric layer 108a may be used as a stop layer for the planarization process. Alternatively, in other embodiments, after the planarization process is performed, the uppermost second dielectric layer 108b in the dielectric stacked structure 108 is exposed, that is, the uppermost second dielectric layer 108b may be used as a stop layer for the planarization process.

The third dielectric layer 114 filled in a vertical hole VH may be regarded as a dielectric pillar. In this way, a plurality of dielectric pillars are formed in the dielectric stacked structure 108 in the staircase region 100b, and the dielectric pillars may be used to provide support for the dielectric stacked structure 108 in the staircase region 100b. In addition, the dielectric pillars may be used as regions to form conductive pillars in subsequent processes, which will be explained later.

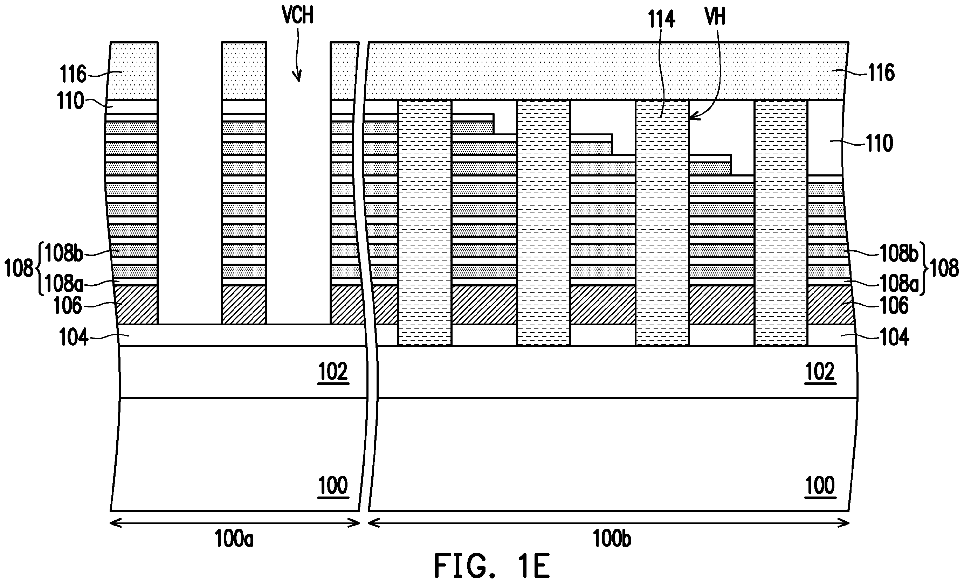

Referring to FIG. 1E, a patterned mask layer 116 is formed on the cap layer 110. In the present embodiment, the patterned mask layer 116 is a photoresist layer, but the present invention is not limited thereto. The patterned mask layer 116 covers the staircase region 100b and exposes a part of the cap layer 110 in the memory array region 100a. Afterwards, the patterned mask layer 116 is used as an etching mask, and an etching process is performed to remove the cap layer 110 exposed by the patterned mask layer 116 and the dielectric stacked structure 108 and the ground layer 106 thereunder to form vertical channel holes VCH. The etching process is, for example, an anisotropic etching process. In the present embodiment, the vertical channel holes VCH expose the top surface of the insulating layer 104, but the present invention is not limited thereto. In other embodiments, the vertical channel holes VCH may be extended into the insulating layer 104.

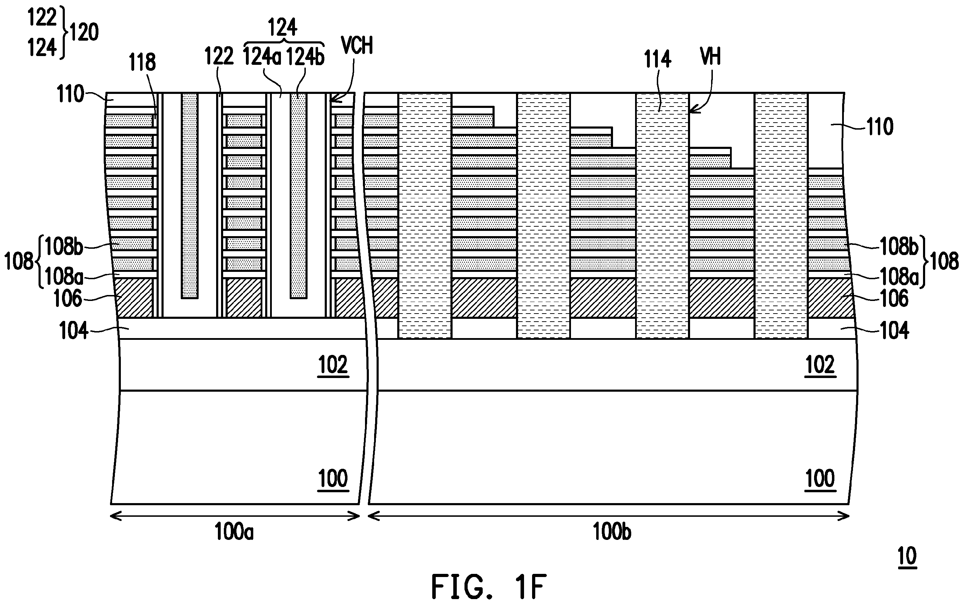

Referring to FIG. 1F, the patterned mask layer 116 is removed. Next, an oxidation process may be performed to oxidize the surfaces of the second dielectric layers 108b and the surface of the ground layer 106 exposed in the vertical channel holes VCH to form the oxide layer 118. The oxide layer 108 may be used as a sacrificial layer in the subsequent process. Then, vertical channel structures 120 are formed in the vertical channel holes VCH to form the semiconductor structure 10 of the present embodiment. In the present embodiment, the vertical channel structure 120 includes a channel layer 122 and a dielectric pillar 124. The vertical channel structure 120 penetrates through the dielectric stacked structure 108 and the ground layer 106. The channel layer 122 is formed on the sidewall of the vertical channel hole VCH, and the dielectric pillar 124 is filled in the vertical channel hole VCH.

In detail, after the oxide layer 118 is formed, the channel layer 122 is formed on the sidewall of the vertical channel holes VCH. The method for forming the channel layer 122 may include the following steps. A channel material layer is conformally formed on the cap layer 110, and then an anisotropic etching process is performed to remove the channel material layer located at the bottom of the vertical channel holes VCH and outside the vertical channel holes VCH. In the present embodiment, the channel material layer is polysilicon layer. Next, a fourth dielectric layer 124a is formed at the bottom of the vertical channel holes VCH and on the channel layer 122, and a fifth dielectric layer 124b is formed to fill in the vertical channel holes VCH. That is, in the present embodiment, the dielectric pillar 124 includes the fourth dielectric layer 124a and the fifth dielectric layer 124b. In the present embodiment, the fourth dielectric layer 124a is an oxide layer, such as a silicon oxide layer, and the fifth dielectric layer 124b is a nitride layer, such as a silicon nitride layer. The method for forming the fourth dielectric layer 124a and the fifth dielectric layer 124b may include the following steps. A dielectric material layer is conformally formed on the cap layer 110, and then another dielectric material layer us formed on the dielectric material layer. After that, an etching back process is performed to remove the dielectric material layers outside the vertical channel holes VCH. In this way, the fifth dielectric layer 124b is formed in the fourth dielectric layer 124a. In the present embodiment, the fourth dielectric layer 124a and the fifth dielectric layer 124b are formed of different dielectric materials, but the present invention is not limited thereto. In other embodiments, the fourth dielectric layer 124a and the fifth dielectric layer 124b may be formed of a single dielectric material, such as silicon oxide or silicon nitride, according to actual needs.

In the present embodiment, the vertical channel holes VCH in the memory array region 100a and the vertical holes VH in the staircase region 100b with different depths are formed in different steps, and thus the difficulty of the process is effectively reduced. In addition, in the present embodiment, since the vertical channel structures 120 and the third dielectric layer 114 in the vertical holes VH are formed in different steps, the same material layers as the vertical channel structures 120 does not need to be formed in the vertical holes VH. That is, the structure in the vertical hole VH may be different from the vertical channel structure 120. In this way, there is no need to perform additional steps in the subsequent process to remove unnecessary layers, such as the channel layer, in the vertical hole VH.

The semiconductor structure 10 of the present embodiment may be used to form a 3D memory. This will be explained below.

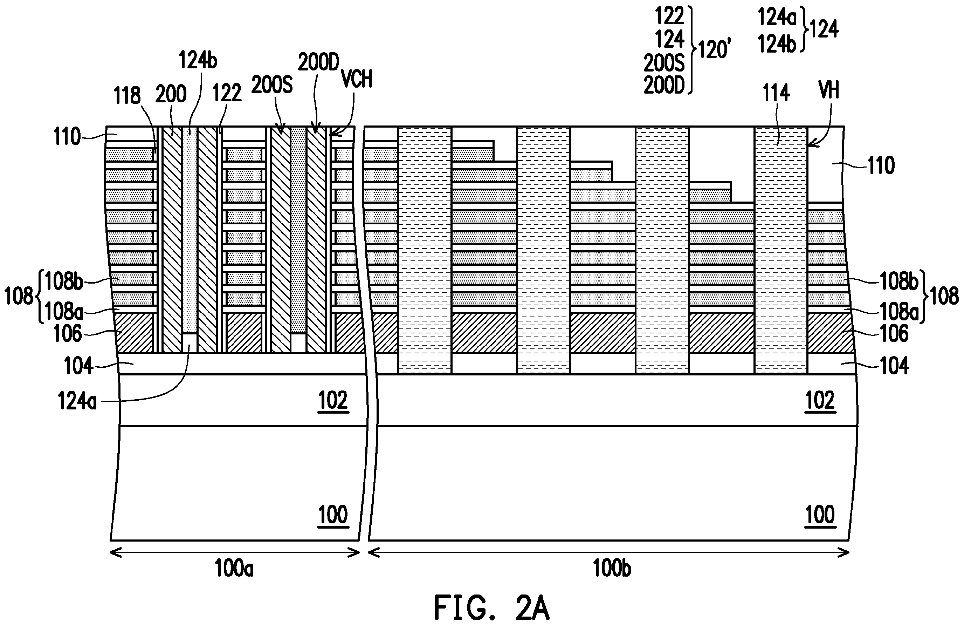

FIGs. 2A to 2C are schematic cross-sectional views of the manufacturing process for a 3D memory of an embodiment of the present invention.

Referring to FIG. 2A, after the semiconductor structure 10 is formed, a part of the fourth dielectric layer 124a between the fifth dielectric layer 124b and the channel layer 122 is removed to form holes penetrating through the dielectric pillar 124. A method for removing a part of the fourth dielectric layer 124a between the fifth dielectric layer 124b and the channel layer 122 is, for example, to perform an anisotropic etching process. At this time, a part of the fourth dielectric layer 124a is remained below the fifth dielectric layer 124b. Next, a conductive layer 200 is formed in the holes to fill the vertical channel holes VCH. In the present embodiment, a material of the conductive layer 200 may be metal or a doped polysilicon. The conductive layer 200 in the vertical channel hole VCH is used as the source pillar 200S and the drain pillar 200D of the 3D memory. That is, the source pillar 200S and the drain pillar 200D are formed in the dielectric pillar 124 and separated from each other. At this time, the vertical channel structure 120' includes the channel layer 122, the dielectric pillar 124, the source pillar 200S and the drain pillar 200D.

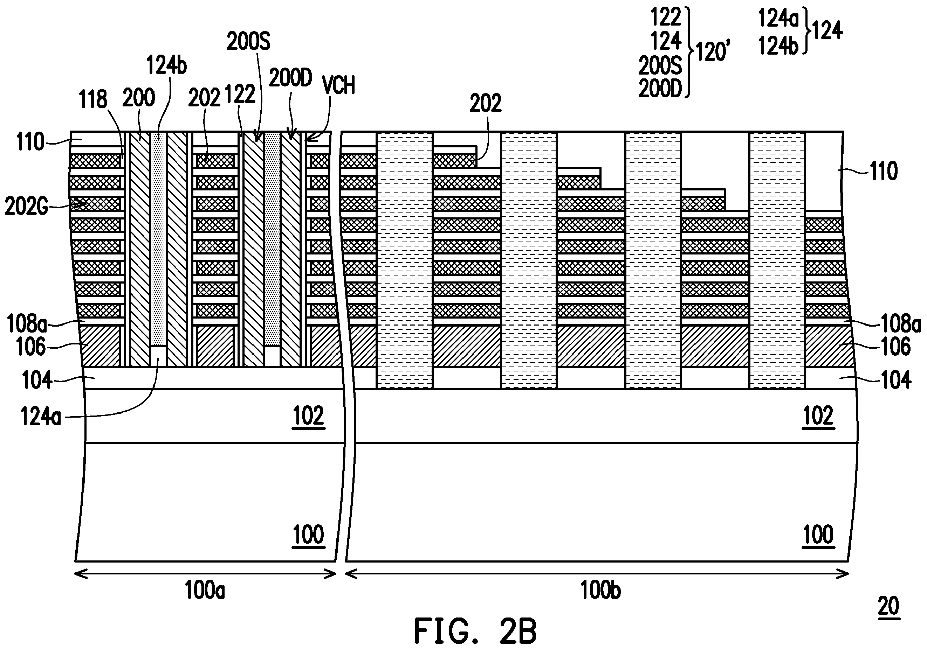

Referring to FIG. 2B, a replacement process and a charge storage structure formation step are performed to replace the second dielectric layer 108b with a conductive layer 202 and form a charge storage structure around the conductive layer 202. In FIG. 2A, the charge storage structure is not shown for clarity of the drawing. The charge storage structure may be a composite structure composed of an oxide layer, a nitride layer and an oxide layer. In the memory array region 100a, the conductive layer 202 may be used as the gate 202G of the 3D memory. In the staircase region 100b, the conductive layer 202 may be used as the word line of the 3D memory. The replacement process and the charge storage structure formation steps are well known to those skilled in the art, and will not be further described here. At this time, the semiconductor structure 20 for forming a 3D memory.

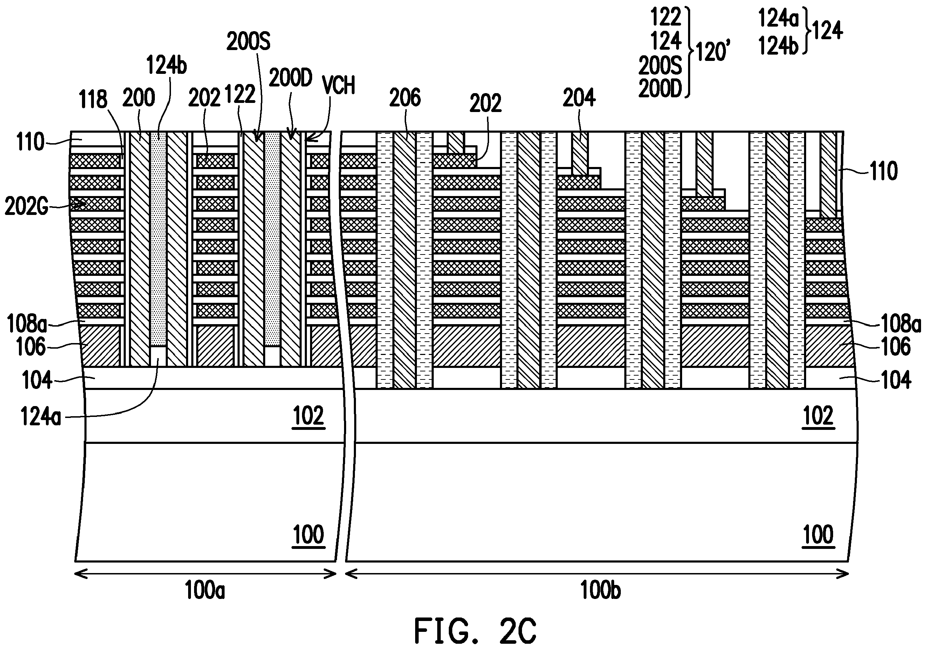

Referring to FIG. 2C, plugs 204 connected to the conductive layers 202 (the word lines) in the staircase region 100b are formed. In this way, the 3D memory of the present embodiment is formed. In addition, depending on actual needs, conductive pillars 206 electrically connected to the device structure layer 102 may be formed in the third dielectric layer 114. The method for forming the plugs 204 and the conductive pillars 206 are well known to those skilled in the art, and will not be further described here.

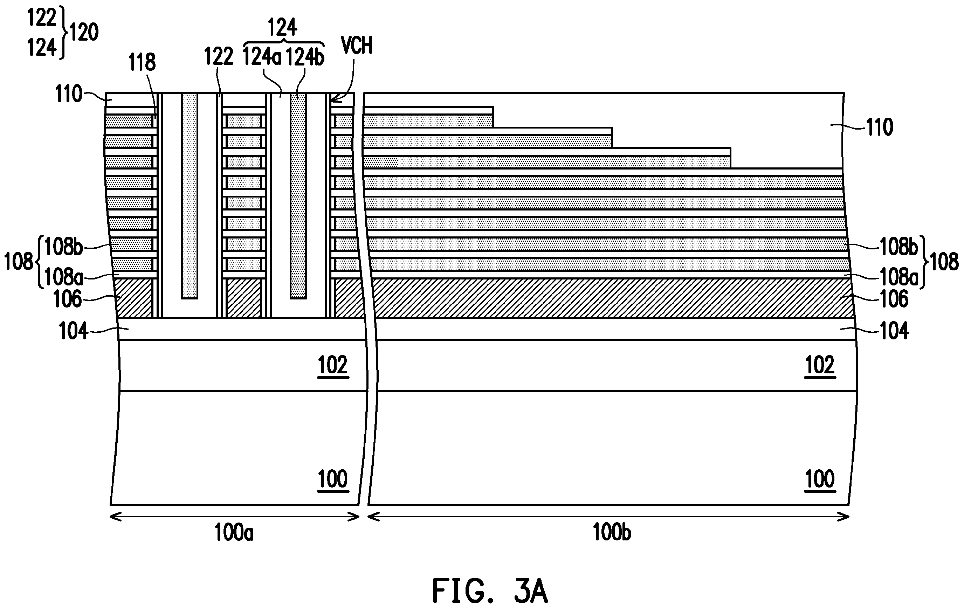

FIGs. 3A to 3C are schematic cross-sectional views of the manufacturing process of a semiconductor structure for a 3D memory of the second embodiment of the present invention. In the present embodiment, the same device as that of the first embodiment will be denoted by the same reference symbols and will not be described again.

In the first embodiment, before the vertical channel structures 120 are formed, the vertical holes VH and the third dielectric layer 114 are formed. In the present embodiment, after the vertical channel structures 120 is formed, the vertical holes VH and the third dielectric layer 114 are formed.

Referring to FIG. 3A, after forming the dielectric stacked structure 108 as shown in FIG. 1B and forming the cap layer 110 as shown in FIG. 1C, the steps described in FIG. 1E and FIG. 1F are performed, and the vertical channel structures 120 are formed in the dielectric stacked structure 108 in the memory array region 100a.

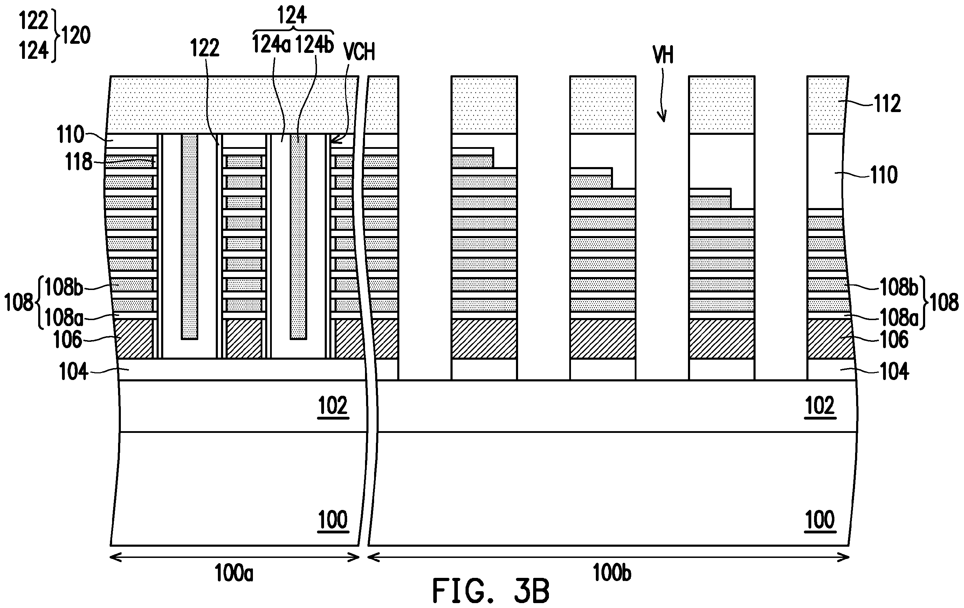

Referring to FIG. 3B, the steps as described in FIG. 1C are performed. The patterned mask layer 112 is formed on the cap layer 110. The patterned mask layer 112 covers the memory array region 100a and exposes a part of the cap layer 110 in the staircase region 100b. Next, the patterned mask layer 112 is used as an etching mask to perform an etching process to remove the cap layer 110 exposed by the patterned mask layer 112 and the dielectric stacked structure 108, the ground layer 106 and the insulating layer 104 thereunder to form the vertical holes VH.

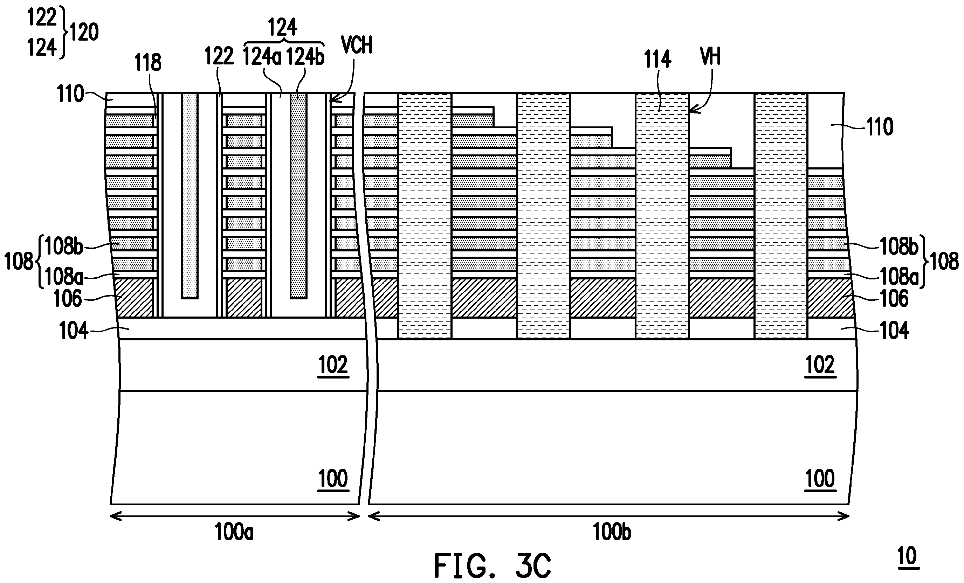

Referring to FIG. 3C, the steps as described in FIG. 1D are performed to remove the patterned mask layer 112. Then, the third dielectric layer 114 is filled in the vertical holes VH. In this way, the semiconductor structure 10 shown in FIG. 1F may also be formed. In addition, after forming the semiconductor structure 10, the steps as described in FIGs. 2A to 2C may be performed to form the conductive 200, the conductive 202, the plugs 204 and the conductive pillars 206 for forming the semiconductor structure 20 and the 3D memory.

In addition, in other embodiments, the vertical holes VH and the third dielectric layer 114 may be formed after the vertical channel structures 120' as shown in FIG. 2A is formed. This will be explained below.

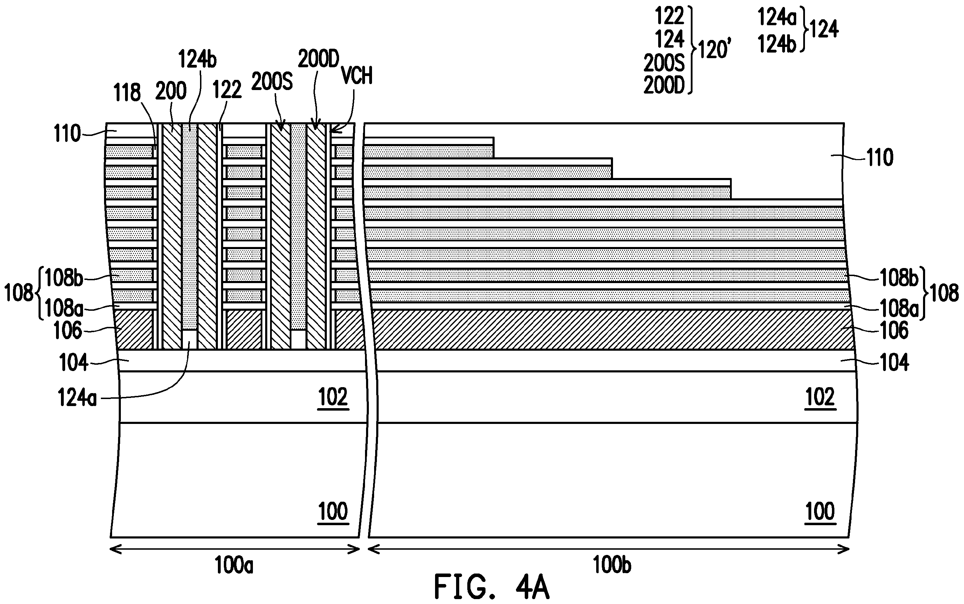

FIGs. 4A to 4C are schematic cross-sectional views of the manufacturing process of a semiconductor structure for a 3D memory of the third embodiment of the present invention. In the present embodiment, the same device as the first embodiment, the second embodiment and FIGs. 2A to 2C will be denoted by the same reference symbols, and no description will be given.

Referring to FIG. 4A, after forming the structure as shown in FIG. 3A, the steps as described in FIG. 2A are performed to form the vertical channel structures 120'.

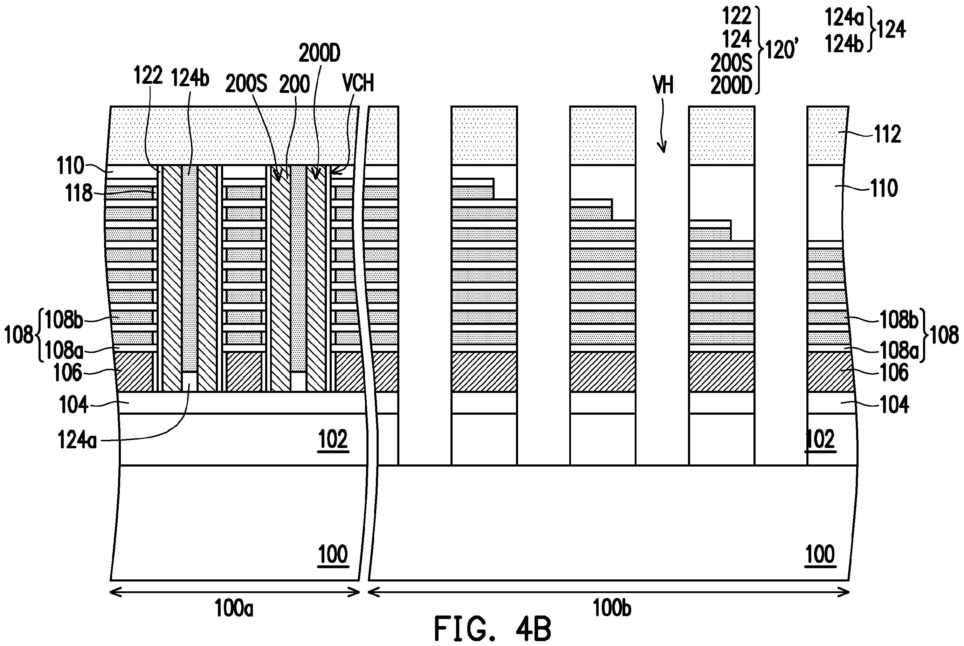

Referring to FIG. 4B, the steps described in FIG. 1C are performed to form the patterned mask layer 112 on the cap layer 110. The patterned mask layer 112 covers the memory array region 100a and exposes a part of the cap layer 110 in the staircase region 100b. Next, the patterned mask layer 112 is used as an etching mask to perform an etching process to remove the cap layer 110 exposed by the patterned mask layer 112 and the dielectric stacked structure 108, the ground layer 106 and the insulating layer 104 thereunder to form vertical holes VH.

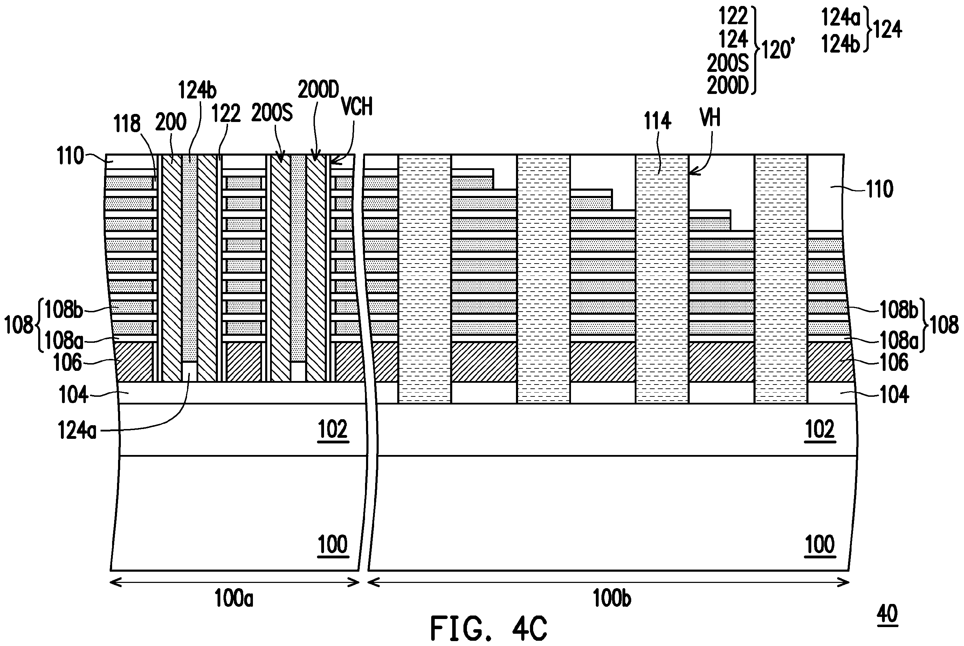

Referring to FIG. 4C, the steps described in FIG. 1D are performed to remove the patterned mask layer 112. Then, the third dielectric layer 114 is filled in the vertical hole VHs. In this way, the semiconductor structure 40 of the present embodiment is formed.

After forming the semiconductor structure 40, the steps as described in FIGs. 2B to 2C may be performed to form the conductive 202, the plugs 204 and the conductive pillars 206 for forming the semiconductor structure 20 and the 3D memory.

In each of the above embodiments, the device structure layer 102 is formed between the substrate 100 and the insulating layer 104 in the memory array region 100a and the staircase region 100b, but the present invention is not limited thereto. In other embodiments, the device structure layer 102 may be formed in a region outside the memory array region 100a and the staircase region 100b.

## Claims

1. A semiconductor structure (10, 20, 40) for a three-dimensional (3D) memory, comprising:
a substrate (100), having a memory array region (100a) and a staircase region (100b);
an insulating layer (104), disposed on the substrate (100);
a stacked structure (108), dispose on the insulating layer (104), wherein the stacked structure (108) comprises a plurality of first dielectric layers (108a) separated from each other, and the stacked structure (108) in the staircase region (100b) has a staircase profile; and
a vertical channel structure (120, 120'), disposed in the stacked structure (108) in the memory array region (100a), and penetrating through the stacked structure (108),
wherein there is a vertical hole (VH) in the stacked structure (108) and the insulating layer (104) in the staircase region (100b), and the third dielectric layer (114) is filled in the vertical hole (VH).

2. The semiconductor structure for a 3D memory of claim 1, wherein the first dielectric layer (108a) comprises an oxide layer.

3. The semiconductor structure for a 3D memory of claim 1, wherein the third dielectric layer (114) comprises an oxide layer.

4. The semiconductor structure for a 3D memory of claim 1, wherein the stacked structure (108) in the memory array region (100a) has a vertical channel hole (VCH), and the vertical channel structure (120, 120') is disposed in the vertical channel hole (VCH).

5. The semiconductor structure for a 3D memory of claim 4, wherein the vertical channel structure (120, 120') comprises:
a channel layer (122), disposed on a sidewall of the vertical channel hole (VCH);
a dielectric pillar (124), filled in the vertical channel hole (VCH); and
a source pillar (200S) and a drain pillar (200D), disposed in the dielectric pillar (124) and separated from each other.

6. The semiconductor structure for a 3D memory of claim 1, wherein the stacked structure (108) further comprises a plurality of gate layers (202G), and the gate layers (202G) and the first dielectric layers (108a) are stacked alternately.

7. The semiconductor structure for a 3D memory of claim 1, further comprising a ground layer (106) disposed between the dielectric stacked structure (108) and the insulating layer (104), wherein the vertical channel structure (120, 120') penetrates through the ground layer (106).

8. The semiconductor structure for a 3D memory of claim 1, further comprising a device structure layer (102) disposed between the substrate (100) and the insulating layer (104), wherein the vertical hole (VH) exposes the device structure layer (102).

9. The semiconductor structure for a 3D memory of claim 8, further comprising a conductive pillar (206) disposed in the third dielectric layer (114) and electrically connected to the device structure layer (102).

10. A manufacturing method of a semiconductor structure (10, 20, 40 for a 3D memory, comprising:
providing a substrate (100), wherein the substrate (100) has a memory array region (100a) and a staircase region (100b);
forming an insulating layer (104) on the substrate (100);
forming a stacked structure (108) on the insulating layer (104), wherein the stacked structure (108) comprises a plurality of first dielectric layers (108a) separated from each other, and the stacked structure (108) in the staircase region (100b) has a staircase profile;
forming a vertical channel structure (120, 120') penetrating through the stacked structure (108) in the stacked structure (108) in the memory array region (100a);
forming a vertical hole (VH) in the stacked structure (108) in the staircase region (100b) and the insulating layer (104); and
filling the vertical hole (VH) with a third dielectric layer (114).

11. The manufacturing method of claim 10, wherein the vertical hole (VH) and the third dielectric layer (114) are formed before the vertical channel structure (120, 120') is formed.

12. The manufacturing method of claim 11, wherein a method for forming the vertical channel structure (120, 120') and the vertical hole (VH) comprises:
forming a cap layer (110) on the stacked structure (108);
removing a part of the cap layer (110), a part of the stacked structure (108) and a part of the insulating layer (104) in the staircase region (100b) to form the vertical hole (VH);
filling the third dielectric layer (114) in the vertical hole (VH);
removing a part of the cap layer (110) and a part of the stacked structure (108) in the memory array region (100a) to form a vertical channel hole (VCH); and
forming the vertical channel structure (120, 120') in the vertical channel hole (VCH).

13. The manufacturing method of claim 12, wherein a method for forming the vertical channel structure (120, 120') comprises:
forming a channel layer (122) on a sidewall of the vertical channel hole (VCH); and
forming a dielectric pillar (124) to fill the vertical channel hole (VCH).

14. The manufacturing method of claim 10, wherein the vertical hole (VH) and the third dielectric layer (114) are formed after the vertical channel structure (120, 120') is formed.

15. The manufacturing method of claim 14, wherein a method for forming the vertical channel structure (120, 120') and the vertical hole (VH) comprises:
forming a cap layer (110) on the stacked structure (108);
removing a part of the cap layer (110) and a part of the stacked structure (108) in the memory array region (100a) to form a vertical channel hole (VCH);
forming the vertical channel structure (120, 120') in the vertical channel hole (VCH);
removing a part of the cap layer (110), a part of the stacked structure (108) and a part of the insulating layer (104) in the staircase region (100b) to form the vertical hole (VH); and
filling the third dielectric layer (114) in the vertical hole (VH).

16. The manufacturing method of claim 15, wherein a method for forming the vertical channel structure (120, 120') comprises:
forming a channel layer (122) on a sidewall of the vertical channel hole (VCH); and
forming a dielectric pillar (124) to fill the vertical channel hole (VCH).

17. The manufacturing method of claim 14, further comprising forming a source pillar (200S) and a drain pillar (200D) in the vertical channel structure (120, 120') after forming the vertical channel structure (120, 120') and before forming the vertical hole (VH) and the third dielectric layer (114).

18. The manufacturing method of claim 17, wherein a method for forming the vertical channel structure (120, 120'), the source pillar (200S), the drain pillar (200D) and the vertical hole (VH) comprises:
forming a cap layer (110) on the stacked structure (108);
removing a part of the cap layer (110) and a part of the stacked structure (108) in the memory array region (100a) to form a vertical channel hole (VCH);
forming the vertical channel structure (120, 120') in the vertical channel hole (VCH), wherein the vertical channel structure (120, 120') comprises a channel layer (122) formed on a sidewall of the vertical channel hole (VCH), a fourth dielectric layer (124a) filled the vertical channel hole (VCH) and a fifth dielectric layer (124b) formed in the fourth dielectric layer (124a);
removing the fourth dielectric layer (124a) between the fifth dielectric layer (124b) and the channel layer (122);
filling a conductive layer (200) between the fifth dielectric layer (124b) and the channel layer (122) to form the source pillar (200S) and the drain pillar (200D);
removing a part of the cap layer (110), a part of the stacked structure (108) and a part of the insulating layer (104) in the staircase region (100b) to form the vertical hole (VH); and
filling the third dielectric layer (114) in the vertical hole (VH).

19. The manufacturing method of claim 10, further comprising forming a conductive pillar (206) in the third dielectric layer (114) after forming the third dielectric layer (114).

20. The manufacturing method of claim 10, wherein the stacked structure (108) further comprises a plurality of gate layers (202G), and the gate layers (202G) and the first dielectric layer (108a) are stacked alternately.

## Amended claims

### Amended claims in accordance with Rule 137(2) EPC.

1. A semiconductor structure (10, 20, 40) for a three-dimensional (3D) memory, comprising:
a substrate (100), having a memory array region (100a) and a staircase region (100b);
an insulating layer (104), disposed on the substrate (100);
a device structure layer (102) disposed between the substrate (100) and the insulating layer (104);
a stacked structure (108), dispose on the insulating layer (104), wherein the stacked structure (108) comprises a plurality of first dielectric layers (108a) and a plurality of gate layers (202G) stacked alternately, and the stacked structure (108) in the staircase region (100b) has a staircase profile, and the stacked structure (108) in the memory array region (100a) has a vertical channel hole (VCH);
a charge storage structure around the gate layers; and
a vertical channel structure (120, 120'), disposed in the vertical channel hole (VCH) of the stacked structure (108) in the memory array region (100a), and penetrating through the stacked structure (108),
wherein there is a vertical hole (VH) in the stacked structure (108) and the insulating layer (104) in the staircase region (100b), and a third dielectric layer (114) is filled in the vertical hole (VH),
**characterized in that** the vertical hole (VH) penetrates through the insulating layer (104) and a bottom of the vertical hole (VH) exposes a top surface of the device structure layer (102), and a bottom of the vertical channel hole (VCH) exposes a top surface of the insulating layer (104).

2. The semiconductor structure for a 3D memory of claim 1, wherein the first dielectric layer (108a) comprises an oxide layer.

3. The semiconductor structure for a 3D memory of claim 1, wherein the third dielectric layer (114) comprises an oxide layer.

4. The semiconductor structure for a 3D memory of claim 1, wherein the vertical channel structure (120, 120') comprises:
a channel layer (122), disposed on a sidewall of the vertical channel hole (VCH);
a dielectric pillar (124), filled in the vertical channel hole (VCH); and
a source pillar (200S) and a drain pillar (200D), disposed in the dielectric pillar (124) and separated from each other.

5. The semiconductor structure for a 3D memory of claim 1, further comprising an electrically grounded conductive layer (106) disposed between the dielectric stacked structure (108) and the insulating layer (104), wherein the vertical channel structure (120, 120') penetrates through the electrically grounded conductive layer (106).

6. The semiconductor structure for a 3D memory of claim 1, further comprising a conductive pillar (206) disposed in the third dielectric layer (114) and electrically connected to the device structure layer (102).

7. A manufacturing method of a semiconductor structure (10, 20, 40 for a 3D memory, comprising:
providing a substrate (100), wherein the substrate (100) has a memory array region (100a) and a staircase region (100b);
forming a device structure layer (102) on the substrate (100);
forming an insulating layer (104) on the device structure layer (102);
forming a stacked structure (108) on the insulating layer (104), wherein the stacked structure (108) comprises a plurality of first dielectric layers (108a) and a plurality of gate layers (202G) stacked alternately, and the stacked structure (108) in the staircase region (100b) has a staircase profile, and the stacked structure (108) in the memory array region (100a) has a vertical channel hole (VCH);
forming a charge storage structure around the gate layers;
forming a vertical channel structure (120, 120') penetrating through the stacked structure (108) in the vertical channel hole (VCH) of the stacked structure (108) in the memory array region (100a);
forming a vertical hole (VH) in the stacked structure (108) in the staircase region (100b) and the insulating layer (104); and
filling the vertical hole (VH) with a third dielectric layer (114)
**characterized in that** the vertical hole (VH) penetrates through the insulating layer (104) and a bottom of the vertical hole (VH) exposes the device structure layer (102), and a bottom of the vertical channel hole (VCH) exposes a top surface of the insulating layer (104).

8. The manufacturing method of claim 7, wherein the vertical hole (VH) and the third dielectric layer (114) are formed before the vertical channel structure (120, 120') is formed.

9. The manufacturing method of claim 8, wherein a method for forming the vertical channel structure (120, 120') and the vertical hole (VH) comprises:
forming a cap layer (110) on the stacked structure (108);
removing a part of the cap layer (110), a part of the stacked structure (108) and a part of the insulating layer (104) in the staircase region (100b) to form the vertical hole (VH);
filling the third dielectric layer (114) in the vertical hole (VH);
removing a part of the cap layer (110) and a part of the stacked structure (108) in the memory array region (100a) to form the vertical channel hole (VCH); and
forming the vertical channel structure (120, 120') in the vertical channel hole (VCH).

10. The manufacturing method of claim 9, wherein a method for forming the vertical channel structure (120, 120') comprises:
forming a channel layer (122) on a sidewall of the vertical channel hole (VCH); and
forming a dielectric pillar (124) to fill the vertical channel hole (VCH).

11. The manufacturing method of claim 7, wherein the vertical hole (VH) and the third dielectric layer (114) are formed after the vertical channel structure (120, 120') is formed.

12. The manufacturing method of claim 11, wherein a method for forming the vertical channel structure (120, 120') and the vertical hole (VH) comprises:
forming a cap layer (110) on the stacked structure (108);
removing a part of the cap layer (110) and a part of the stacked structure (108) in the memory array region (100a) to form a vertical channel hole (VCH);
forming the vertical channel structure (120, 120') in the vertical channel hole (VCH);
removing a part of the cap layer (110), a part of the stacked structure (108) and a part of the insulating layer (104) in the staircase region (100b) to form the vertical hole (VH); and
filling the third dielectric layer (114) in the vertical hole (VH).

13. The manufacturing method of claim 12, wherein a method for forming the vertical channel structure (120, 120') comprises:
forming a channel layer (122) on a sidewall of the vertical channel hole (VCH); and
forming a dielectric pillar (124) to fill the vertical channel hole (VCH).

14. The manufacturing method of claim 11, further comprising forming a source pillar (200S) and a drain pillar (200D) in the vertical channel structure (120, 120') after forming the vertical channel structure (120, 120') and before forming the vertical hole (VH) and the third dielectric layer (114).

15. The manufacturing method of claim 13, wherein a method for forming the vertical channel structure (120, 120'), the source pillar (200S), the drain pillar (200D) and the vertical hole (VH) comprises:
forming a cap layer (110) on the stacked structure (108);
removing a part of the cap layer (110) and a part of the stacked structure (108) in the memory array region (100a) to form a vertical channel hole (VCH);
forming the vertical channel structure (120, 120') in the vertical channel hole (VCH), wherein the vertical channel structure (120, 120') comprises a channel layer (122) formed on a sidewall of the vertical channel hole (VCH), a fourth dielectric layer (124a) filled the vertical channel hole (VCH) and a fifth dielectric layer (124b) formed in the fourth dielectric layer (124a);
removing the fourth dielectric layer (124a) between the fifth dielectric layer (124b) and the channel layer (122);
filling a conductive layer (200) between the fifth dielectric layer (124b) and the channel layer (122) to form the source pillar (200S) and the drain pillar (200D);
removing a part of the cap layer (110), a part of the stacked structure (108) and a part of the insulating layer (104) in the staircase region (100b) to form the vertical hole (VH); and
filling the third dielectric layer (114) in the vertical hole (VH).

16. The manufacturing method of claim 7, further comprising forming a conductive pillar (206) in the third dielectric layer (114) after forming the third dielectric layer (114).
